(19) Europäisches Patentamt
European Patent Office
Office européen des brevets

(11) EP 0 552 984 B1

(12) **EUROPEAN PATENT SPECIFICATION**

(45) Date of publication and mention of the grant of the patent:
**26.08.1998 Bulletin 1998/35**

(51) Int Cl.[6]: **H05K 3/46**, H05K 3/38, H01L 21/48

(21) Application number: **93300488.9**

(22) Date of filing: **22.01.1993**

(54) **Methods of making thin-film wiring boards**

Verfahren zur Herstellung von Dünnfilm-Leiterplatten

Procédés de fabrication de plaques de circuit à film mince

(84) Designated Contracting States:
**DE FR GB**

(30) Priority: **22.01.1992 JP 9049/92**

(43) Date of publication of application:
**28.07.1993 Bulletin 1993/30**

(73) Proprietor: **HITACHI, LTD.**
**Chiyoda-ku, Tokyo 100 (JP)**

(72) Inventors:
- **Okabe, Yoshiaki**
  **Ibaraki 317 (JP)**
- **Tawata, Rie**
  **Ibaraki 309-17 (JP)**
- **Fujisaki, Koji**
  **Ibaraki 316 (JP)**
- **Ikeda, Takayoshi**
  **Ibaraki 319-11 (JP)**
- **Miwa, Takao**
  **Ibaraki 312 (JP)**
- **Katagiri, Junichi**
  **Ibaraki 311-01 (JP)**
- **Takahashi, Akio**
  **Ibaraki 313 (JP)**

(74) Representative: **Stoner, Gerard Patrick et al**
**MEWBURN ELLIS**
**York House**
**23 Kingsway**
**London WC2B 6HP (GB)**

(56) References cited:
**EP-A- 0 361 462** **EP-A- 0 389 951**
**EP-A- 0 400 332**

- **PATENT ABSTRACTS OF JAPAN vol. 014, no. 380 (E-0965)16 August 1990 & JP-A-02 138 788 (HITACHI CHEMICAL CO.) 28 May 1990 & JP-B-3 012 592 (...)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 552 984 B1

## Description

This invention relates to methods of making wiring boards.

Multilayer thin-film wiring boards are well-known in the art. They are widely used for the wiring of computers. As computer technology becomes more advanced, the packaging density of the circuitry must increase. High density circuitry requires high conductivity wiring, separated by an insulator with a good dielectric constant.

Polyimide is a desirable insulating material. However, it has some processing difficulties.

In the prior art, JP-A-2/092535 describes forming a multilayer board by applying a polyamic ester varnish to the copper-wired surface of a polyimide substrate sheet, curing the varnish to polyimide, polishing the polyimide surface, depositing a subsequent copper wiring pattern on the polished polyimide surface, varnish-coating the subsequent copper wiring, and so on. This process is laborious, because of the time consuming steps of polishing and copper deposition which intersperse the varnish application steps.

EP-A-0361462 describes a similar process for producing metal/polyimide composite articles using a varnish based on polyamic acid ester precursor.

Another known assembly method uses prefabricated solid polyimide bonding films containing a thermosetting adhesion promoter. The bonding films are inserted between the wiring sheets, and heat and pressure are applied to bond the sheets together by polymerising the adhesion promoter. JP-A-3/12592 describes such films in which the adhesion promoter is a maleimide-terminated compound.

EP-A-0389951 describes another process where, instead of using prefabricated bonding films, a varnish based on polyamic acid, a thermosetting maleimide adhesion promoter and a solvent is used. The varnish is coated on a sheet surface opposite the metal wiring, cured to remove solvent and convert the polyamic acid into polyimide, and heat and pressure are applied to bond the sheets together by polymerising the adhesion promoter.

It is an object of the present invention to provide a method for making a wiring board, particularly having a fine pattern formed thereon, and having at least two bonded wired surfaces, without voids, by using a liquid bonding material having self-fluidity. To obtain good adhesion between the wired surfaces to be bonded, appropriate pressure is applied during the bonding. In the previous bonding methods using bonding film or varnish, the bonding film or cured varnish (without self-fluidity) must deform under pressure to fill interstices or recesses on the wiring board during bonding. Therefore, the known method is inappropriate for use with fine wiring patterns because a method using high pressure has a tendency to destroy the pattern, and even then is unable to obviate entirely the presence of interstices or recesses at the faces of the wired board.

It is a further object of the present invention to provide a novel process for making a wiring board, avoiding at least some of the disadvantages of the above-described prior art methods.

The method of the invention is defined by the features of claim 1.

According to one aspect of this invention, we bond together successive wiring sheets of a wiring board by forming a polyimide-containing layer in situ on the surface of the first of the wiring sheets. This is done by applying a liquid varnish, containing a polyimide precursor or a soluble polyimide, to the wired surface and then drying the varnish to form the polyimide-containing layer. The varnish also contains a polymerizable compound, preferably a cross-linkable compound such as the maleimide-terminated type, which serves for thermosetting of the polyimide-containing layer.

A subsequent wiring sheet is then superimposed over the polyimide layer, pressed against it, and the adhesion promoter polymerised - typically by application of further heating - to bond the layers together.

Because the bonding layer is applied as a liquid varnish, it is possible to get good conformity and bonding even with high-density, thick wiring on the wired surface.

The polyimide-forming varnish usually contains a precursor of the polyimide, although it may in some cases be soluble polyimide. The precursor is a precursor which is free of carboxylic acid groups, such as a masked polyamic acid ester, and most preferably a polyamic acid ester. In a polyamic acid, the polar acid groups contribute to a relatively high viscosity of the varnish, limiting the proportion of polyamic acid that can be used in the varnish. This in turn limits the flatness of polyimide surface that can be achieved over a high-profile wiring, which in turn affects the bonding integrity.

Polyamic acid ester is particularly preferred and gives a low viscosity varnish, so the varnish can contain proportionately less solvent.

The varnish preferably contains 20-95wt% solvent, preferably 30-90wt% solvent, more preferably 35-70wt% solvent.

Polyimide precursor may suitably be according to the formula

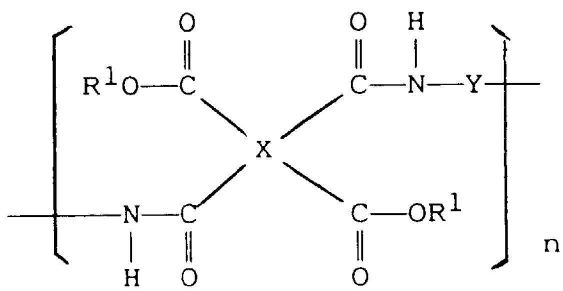

X is an organic moiety having from 1 to 100 carbon atoms. In practice, it is generally the central residue of a dianhydride from which the polyamic acid ester is synthesised. Dianhydrides for making polyimides in this context are well known, and the moiety X may be any of the conventional types. Usually it is $C_4$ to $C_{100}$, more usually $C_6$ to $C_{50}$. It may commonly be aromatic, with one or more aromatic rings.

Suitable examples include pyromellitic dianhydrides, benzophenonetetracarboxylic dianhydride, diphenyltetracarboxylic dianhydride, naphthalenetetracarboxylic dianhydride, diphenylsulfonetetracarboxylic dianhydride, diphenylmethanetetracarboxylic dianhydride, terphenyltetracarboxylic dianhydride, oxydiphthalic anhydride, bis(4-phthalic anhydride) propane, 2,2-bis(4-(3,4-dicarboxyphenoxy)phenyl)propane dianhydride, 2,2-bis(4-(3,4-dicarboxyphenoxy) phenyl)hexafluoropropane dianhydride, 2,2-bis(3,4-dicarboxyphenyl)hexafluoropropane dianhydride, 2,2-bis(3,4-dicarboxyphenyl)propane dianhydride, trifluoromethylpyromellitic dianhydride, 1,2,3,4-cyclopentanetetracarboxylic dianhydride, and 3,3',4,4'-benzyltetracarboxylic dianhydride.

Y is also an organic moiety having from 1 to 100 carbon atoms. In practice, it is generally the residue of a diamine used in synthesising the polyamic acid ester. Again, these diamines are in themselves well known for polyimide preparation, and any of the conventional ones may be used. Typically it will be $C_2$ to $C_{100}$, more usually $C_6$ to $C_{50}$, and is preferably aromatic with one or more aromatic rings.

Suitable examples include phenylenediamines, diaminotoluenes, diaminopyridines, 4,4'-diaminodiphenylether, diaminodiphenylsulfones, diaminonaphthalenes, xylenediamines, tetramethyl-p-phenylenediamine, 4,4'-diaminodiphenylmethane, 4,4'-diaminodiphenylsulfide, 4,4"-diaminoterphenyl, diaminobenzophenones, 4,4'-diaminodicyclohexylmethane, 4'4-bis(p-aminophenoxy)diphenylsulfone, bis[4-(3-aminophenoxy)phenylsulfone], 4,4'-bis(aminophenoxy) biphenyl, 2,2-bis[(aminophenoxy)phenyl]propane, 3,3'-dimethyl-4,4'-diaminodiphenylmethane, 1,3-bis(3-aminophenoxy)benzene, 2,7-diaminofluorene, 3,3'-dimethoxy-4,4'-diaminobiphenyl, 2,2-bis[4-(aminophenoxy )phenyl]hexafluoropropane, 2,6-diaminoanthraquinone, benzoguanamine, acetoguanamine, 4,4'-dithiodianiline, octafluorobenzidine and tetrafluoro-p-phenylenediamine.

The diamine may also be selected from the following compounds:

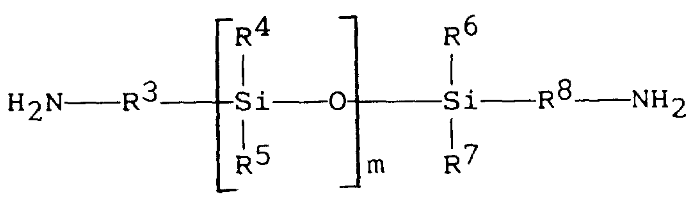

in which

m is from 1 to 10;
$R^3$ and $R^8$ are divalent hydrocarbon moieties such as $C_{1-8}$ alkylene, or phenylene; and
side groups $R^4$, $R^5$, $R^6$ and $R^7$, which may be the same as or different from each other, are typically $C_{1-15}$ hydrocarbyl such as $C_{1-4}$ alkyl, preferably methyl, or aryl such as phenyl.
$R^1$ is H or, a carboxyl-free organic moiety having from 1 to 30 carbon atoms. In practice, it is typically the residue of an alcohol used to synthesise the polyamic acid ester. Its chemical nature is not critical, and a skilled person will be able without difficulty to select a suitable moiety in which $R^1$ is easily separable from the polyimide precursor during heating for imidization. It may be unsaturated. It may include heteroatoms, although more commonly it will be hydrocarbyl, e.g. $C_{1-8}$ alkyl.

The preferred value of n is 6 to 300.

It is also possible to use a "soluble polyimide", meaning a polyimide soluble in a solvent. Generally it is made by imidizing, thermally or chemically, a polyamide acid obtained by equivalence reaction of acid dianhydride and diamine. Preferred examples of acid dianhydrides and diamines which can give a soluble polyimide are as follows:

<u>acid dianhydride</u>
3,3',4,4'-benzophenone tetracarboxylic dianhydride
3,3',4,4'-biphenyl tetracarboxylic dianhydride
3,3'4,4'-diphenylsulfone tetracarboxylic dianhydride
<u>diamine</u>
4-methyl-3,4'-diaminodiphenylether
2,4-diaminotoluene
1,4-bis(4-aminophenoxy)benzene
1,3-bis(4-aminophenoxy)benzene
bis[4-(4'-aminophenoxy)phenyl]sulfone
2,2-bis[4-(4'-aminophenoxy)]propane.

Polyimides made from the monomers above are soluble in NMP.

The polymerizable compound is, as mentioned above, preferably a thermosetting compound. Preferably its polymerisation/cross-linking conditions are such that it does not react substantially as the solid polyimide layer is formed. In particular, preferably it requires a higher thermosetting temperature than that used to form the polyimide layer.

Suitable polymerizable groups for the compound are vinylene, ethynyl, biphenylene and benzocyclobutene.

A preferred polymerizable compound has vinylene terminal groups such as maleimide groups, e.g. may be of the following formula:

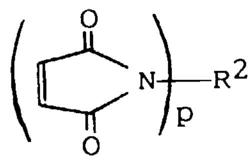

in which p is 2 or 3 and $R^2$ is an organic radical having not more than 100 carbon atoms, typically 2 to 50 carbon atoms. Maleimide compounds of this type are known for this adhesion promoting purpose, e.g. from JP-A-3/12592, and a skilled man will be able to select a suitable one without difficulty. Commercially available polymaleimides typically have $R^2$ in which phenylene groups alternate with one or more oxygen, sulfur or methylene groups in a chain. Suitable examples include N,N'-(4,4'-diphenylmethane) bismaleimide, N,N'-(4,4'-diphenyloxy) bismaleimide, N,N'-phenylene bismaleimide, N,N'-m-phenylene bismaleimide, N,N'-2,4-tolylenebismaleimide, N,N'-2,6-tolylenebismaleimide, N,N'-2,4-ethylene bismaleimide, N,N'-hexamethylene bismaleimide, 2,2-bis [4-(4-N-phenoxymaleimide)phenyl]-propane, 2,2-bis[4-(4-N-phenoxymaleimide)phenyl] hexafluoropropane, 2,2-bis[4-(2trifluoromethyl-4-N-phenoxymaleimide) phenyl] hexafluoropropane, 1,3,5-tris(N-maleimide) benzene and N,N',N''-(4,2',4'-diphenylmethane) trismaleimide. One or a mixture of these may be used.

We find that compounds having only one vinylene terminal group per molecule give less bonding force, although their melt flow is good. Conversely, compounds having more than three vinylene groups tend to cause brittleness, although their bonding is strong.

The polyimide precursor or soluble polyimide is dissolved, along with the polymerizable compound, in a suitable organic solvent to form the liquid varnish. The skilled person is familiar with varnishes in this context, and will be able to select a suitable solvent without difficulty. Examples include N-methyl-2-pyrrolidone (NMP), dimethylacetoamide, dimethylformamide, diglyme, phenol and toluene. They may be used singly or in a suitable mixture.

Usually, the relative proportion by weight of polyimide/precursor to polymerizable compound in the varnish is in the range 10:90 to 90:10, more usually 20:80 to 70:30. If there is too much polymerizable compound, the bond tends to be brittle. If there is too little, the bonding strength is insufficient.

To form the polyimide film in situ from the polyimide precursor in the varnish, the processing temperature and time should be selected in dependence on the structure of the precursor, the type of solvent, and the reactivity of the polymerizable compound. Typically this involves heating at a first, lower temperature to dry off the solvent and then at a second, higher temperature to cause imide-formation. The second temperature should not be such as to react the polymerizable compound, however.

Typically drying is at from 60°C to 150°C, for a period of 10 to 100 minutes. The typical imidization step is at a temperature of from 150°C to 250°C for 10 to 100 minutes, more usually 30 to 60 minutes.

When the subsequent wiring sheet is placed on the bonding layer, pressure is desirably applied e.g. in a conventional laminating press. Mechanical pressure of from 3 to 60kgf/cm$^2$ (1 kgf/cm$^2$ = 0.9807 bar) is typical, and is preferably applied under vacuum. The other conditions depend on the polymerisation conditions of the polymerizable compound. For a typical polymaleimide compound, suitable conditions may be heating at a temperature of from 200°C to 300°C for e.g. 10 to 120 minutes, more usually 20 to 90 minutes.

The varnish is applied to the surface of the underlying wiring sheet or, in another aspect of the invention, to the (usually ceramic) substrate (with or without wiring) at the base of the wiring board. Wiring on the wired surface is preferably copper wiring. If a carboxylic-free varnish is used, however, such as polyamic acid ester varnish, it may be applied directly to exposed copper wiring without adverse consequences. This saves processing time.

In a further embodiment of the invention, the above-described bonding process is carried out repeatedly for a plurality of wiring sheets, to form a multilayer wiring board. Preferably, each successive wiring sheet is presented for bonding with its wiring pattern already formed thereon e.g. in copper on polyimide film. After the wiring sheet is bonded, electrical connections are made through through-holes to the underlying layer. Usually this is by forming the through-holes after bonding e.g. using drilling or a laser beam. Electrical connection is typically made by controlled plating e. g. of copper, through the holes, in a manner which is well-known.

The invention also extends to the products directly obtained by the described methods. Specific aspects of the invention as defined in claim 1 include the following.

A method of manufacturing a thin film wiring board for mounting a semiconductor chip may comprise the steps of:

(a) providing a first wiring sheet comprising a substrate of a polymeric material and wiring lines of a conductive material formed on the substrate;
(b) applying a liquid varnish layer to cover the wiring lines and fill interstices of the wiring lines and the surfaces of the substrate, said varnish comprising

a polyimide ingredient selected from the group consisting of a solvent-soluble polyimide and a precursor of a polyimide,
a polymerizable compound, and
a solvent for dissolving the polyimide ingredient and the polymerizable compound;

(c) drying the varnish layer to form a hardenable layer comprising polyimide;
(d) pressing the hardenable layer against another surface to be bonded; and
(e) polymerizing the polymerizable compound in the hardenable layer to bond the first wiring sheet to another surface.

A further method of manufacturing a thin film wiring board for mounting a semiconductor chip may comprise the steps of:

(a) providing a first wiring sheet comprising a substrate of a polymeric material and a wiring of a conductive material formed on the substrate;
(b) applying a liquid varnish layer covering the wiring and surfaces between the wiring, said varnish comprising

a member selected from the group consisting of polyimide, a precursor of a polyimide, and mixtures thereof;
a polymerizable adhesion promotor, and
an organic solvent for solving the polyimide and the adhesion promotor;

(c) drying the varnish layer to form a hardenable layer comprising a member selected from the group consisting of the polyimide, and a mixture of the polyimide and the precursor thereof, while keeping the promotor unpolymerized;
(d) pressing the hardenable layer to a surface of a ceramic wiring board; and
(e) polymerizing the promotor in the hardenable layer to bond the wiring to the ceramic wiring board.

A thermosetting adhesive material comprising

(i) a member selected from the group consisting of a polyimide and a polyimide precursor convertable to polyimide upon heating above an imidization temperature;
(ii) a polymerizable compound to form a cross-linked polymer upon polymerization above a polymerization temperature higher than said imidization temperature, and
(iii) an organic solvent for dissolving the polyimide may be used.

A further method of manufacturing a multi-layered thin film wiring board for mounting a semiconductor chip thereon may comprise the steps of:

(a) providing a first wiring sheet comprising a substrate of a polymeric material and a wiring of a conductive material formed on the substrate;
(b) applying a liquid varnish layer covering the wiring and surfaces between the wiring, said varnish comprising a polyimide and/or a precursor of a polyimide, a polymerizable adhesion promotor and an organic solvent for solving the polyimide and the promotor;
(c) drying the varnish layer to form a hardenable layer of the polyimide or a mixture of the polyimide and the precursor, while keeping the promotor unpolymerized;
(d) pressing the hardenable layer to a surface of a second wiring on a second substrate;
(e) polymerizing the promotor in the hardenable layer to bond the first wiring to the rear surface of the second wiring;
(f) forming through-holes in the second wiring and its substrate;
(g) electrically connecting the first wiring and the second wiring through the through-holes; and
(h) repeating the steps (b) to (g) until a desired number of layers of the wiring is obtained.

A multi-layered assembly for mounting semiconductor chips, which comprises a laminate of thin film wiring board may comprise

a plurality of wiring layers each being adhered to respective substrates of a polymeric material,
thermosetting polyimide-containing layers each being filled in interstices between the substrates and wiring layers, and
a ceramic wiring board adhered to the laminate;
wherein the wiring layers are electrically connected through through-holes formed in the substrates and the surfaces of said wiring layers are covered with a thin layer of the polyimide-containing layer, said polyimide-containing layer being a cured composition of (i) a polyimide or a polyamic acid or polyamic acid ester imidizable upon heating to a imidization temperature, and (ii) a monomer polymerizable upon heating at a temperature higher than said imidization temperature.

Embodiments of the invention are now described by way of example with reference to the drawings, in which

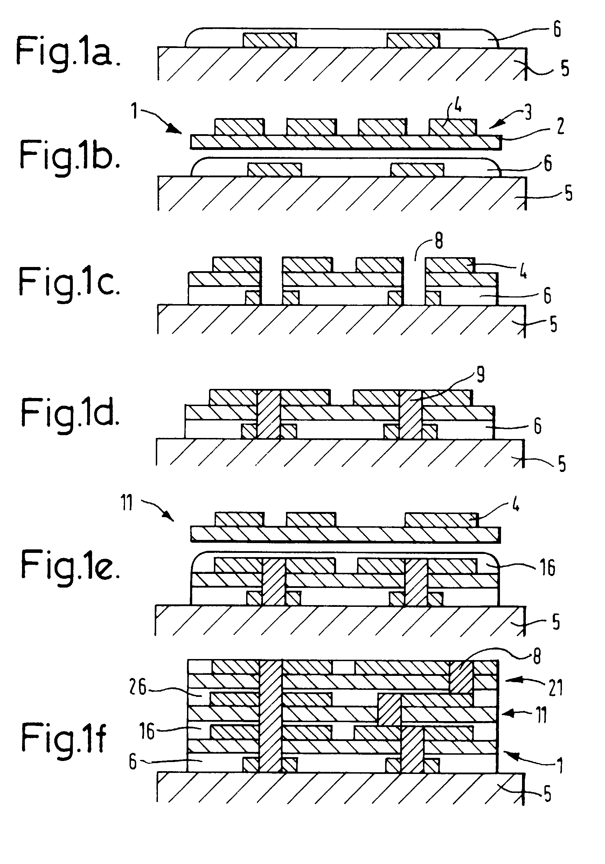

Fig. 1 illustrates schematically the assembly steps of a wiring board, and more specifically
Fig. 1(a) shows a wired ceramic substrate, with applied bonding varnish;
Fig. 1(b) shows application of a first wiring sheet for bonding onto the substrate;
Fig. 1(c) shows the forming of through-holes;
Fig. 1(d) shows plating through the through-holes;
Fig. 1(e) shows the forming of a polyimide bonding layer and superposition of a further wiring sheet, and
Fig. 1(f) shows a multilayer wiring board.

EMBODIMENT 1

Fig.1 illustrates a production process of a multilayered wiring board, embodying the present invention.

Fig. 1(a) shows schematically a ceramic substrate 5 of generally known type, having a wired top surface with connecting terminals or circuit wiring.

Fig.1 (b) shows additionally a sectional view of a superimposed first wiring sheet 1 whose circuit wiring 4 (20μm line space) has been formed on the upper, wired surface 3 by etching, after copper clad metal (clad film 18μm thick, on a 20μm thick polyimide substrate film 2, has been subjected to resist patterning. The wiring sheet 1 is fixed onto the ceramic substrate 5, using a polyamic acid ester and an adhesion promotor (polymerizable compound) comprising maleimide groups in a bonding varnish 6 using NMP as solvent. The varnish is heated at 100°C to 150°C for 20 minutes to one hour, so that the solvent evaporates from the varnish, and is then heated at a temperature of from 150° to 250°C for ten minutes to two hours, so that the polyamic acid ester is wholly or partially imidized. Then the wiring sheet 1 is placed on the imidized layer 6 and subjected to laminate pressing (3 to 50 kgf/cm$^2$, 270°C for one hour) producing a first laminate. The polyimide surface, which is the bonding face of the substrate of the wiring sheet 1, is desirably subjected to plasma processing to ensure better bonding. The bonding varnish 6 may be applied by the spin coat method or cast method. Alternatively, at this first stage of bonding the wiring sheet to the ceramic substrate, the bonding

agent may be used in the form of a prefabricated bonding sheet.

Fig. 1(c) shows through-holes 8 (20μm in diameter) prepared by a rotary drill or laser beam. Fig. 1(d) shows the through-holes 8 having been treated by chemical copper plating to form electrically conductive connections 9. These steps are conventional.

Fig. 1(e) illustrates how a layer of bonding varnish 16 - the same varnish as previously described - is spin-coated onto the first wiring sheet 1 (optionally subjected to chemical plating on the wiring). Since the varnish is fluid - and especially if it is a low-viscosity varnish obtainable using a polyamic acid ester - it effectively occupies the fine interstices of the wiring pattern and contacts the intervening surface portions of the substrate. It is dried and made into imide under the above-mentioned conditions. A further wiring sheet 11, similar to that shown in (b) and described above, is placed on it and subjected to laminate pressing (3 to 50 kgf/cm$^2$, 270°C for twenty minutes to one hour) to produce a laminate.

Fig. 1(f) shows a multilayered wiring board produced by repeating processes (c), (d) and (e) mentioned above, with further wiring sheets 11,21 and intermediate bonding varnish layers 16,26.

A variety of bonding varnish types may be used. The bonding varnish used in the production of the multilayered wiring board of this first embodiment was produced according to the following procedure:

To make a polyamic acid ester, about 300 grams of dried ethyl alcohol was added to 3,3',4,4'-benzophenone tetracarboxylic acid dianhydride (0.13 mols), and refluxed for five hours. After that, excess ethyl alcohol was removed, obtaining light brown crystalline benzophenone tetracarboxylic acid diethyl ester (including the isomer).

This was followed by putting 10 grams (0.026 mols) of the said diethyl ester and thionyl chloride into a four-neck flask having an agitator, thermometer, nitrogen gas feed tube, and cooling tube with calcium chloride tube. The contents were refluxed for 0.5 hours, and excess thionyl chloride removed, thereby getting the high-viscosity acid (containing isomer) which is transparent brown-colored.

Then 10 grams (0.024 mols) of the said acid chloride, NMP (NMP was the solvent used in all the subsequent embodiments and comparisons) and 23 grams (0.07 mols) of 2,2-bis(4-(4-aminophenoxy)phenyl) propane were put into a four-neck flask having an agitator, thermometer, nitrogen gas feed tube and cooling tube with calcium chloride tube, and stirred for three hours. After that, the reaction liquid was precipitated in water, and filtered to obtain a fibrous polymer, which was dried to get the polyamic ester.

70 grams of the said polyamic ester, 30 grams of N,N'-(4,4'-diphenylmethane) bismaleimide and 150 grams of NMP (40 wt. % concentration for resin content) were combined and dissolved, and passed through a 5-μm filter to give the bonding varnish.

Test Procedures

In our experiments, the following methods were used to measure the characteristics of the each synthesized bonding agent and its bonded products.

(1) Thermal expansion coefficient and glass transition temperature.

The thermal expansion coefficient (hereafter referred to as $\alpha$) was measured by a thermophysical tester (TMA-3000 by Shinku Riko Co., Ltd.). A 20μm thick, 6mm wide cured bonding agent sample was loaded in the thermophysical tester, and the film elongation measured under the conditions of 1μm film thickness, 0.3-gram load and temperature rise rate of 5°C per minute. The thermal expansion coefficient was calculated from the elongation rate from 100 to 250°C, according to the temperature curve for elongation. The intersection of two straight lines whose inclinations for elongation temperature curve differ greatly was taken as the glass transition temperature (hereinafter referred to as "Tg").

(2) Peeling strength and tensile strength of the bonding agent.

To measure peeling strength of the bonding agent from copper, the varnish was spin-coated (about 20μm thick after hardening) onto copper foil (20μm thick), dried, converted into imide and cross-linked. It was formed into a 1cm-wide rectangular shape, and used as a peeling test piece, pulled by a universal tensile strength tester (by Toyo Baldwin Co., Ltd.). Measurement was at a pulling angle of 90° and pulling rate of 0.5mm per minute.

The copper content of the cured varnish was also checked.

To measure the tensile strength, the agent was spin-coated on a silicon wafer, dried, converted into imide and cross-linked to get about 20μm thick adhesive agent coating layer. This was peeled from the silicon wafer, dried, formed into a 1cm-wide rectangular shape, and used as a test piece. The test piece was pulled by a universal tensile strength tester (by Toyo Baldwin Co., Ltd.), with measurement at a pulling rate of 0.5mm per minute.

(3) Degree of flattening.

Bonding varnish was applied to a glass-made mock or sham wiring pattern (test pattern) having a line width of 20µm, line space of 20µm and height of 20µm, and cured according to the method given above. The thickness of the cured varnish of this section was measured to obtain a degree of flattening (using the following equation), with a bonding layer thickness of 23 ±2µm. The closer the value to 1, the better the flatness.

$$\text{Degree of flattening} = 1 - (H/h_0)$$

where

H: height of unevenness of polyimide

$h_0$: wiring height (20µm) (4) Soldering resistance test.

A wiring board (see Fig.1) composed of three layers was placed in a soldering bath at a temperature of 330°C for five minutes, and any blister and peeling were observed, for evaluation of thermal resistance.

The cured bonding layer of the above-described specific varnish (Embodiment 1) exhibited excellent characteristics in the described tests: Tg of 220°C, $\alpha$ of 4.8 x $10^{-5}$/K, flattening degree of 0.9, peeling strength of 550 gf/cm, tensile strength of 12 kgf/$mm^2$ and breaking elongation of 10 percent. It contained less than 0.001wt% copper (measured by the atomic absorption method), had a yellow orange color, and was the same in its properties as when formed and cured on an inactive silicon wafer. Accordingly, no problem occurs with this insulation layer when it is applied directly on copper wiring. No problem was noted in the soldering resistance test.

## EMBODIMENT 2

The same polyamic acid ester as in Embodiment 1 was used, with the N,N'-(4,4'-diphenylmethane) bismaleimide constituting 40wt% of its combination with the polyamic acid ester, and producing a bonding varnish having a resin concentration of 40 wt %. The solvent was the same as in Embodiment 1.

After drying and curing, this varnish exhibited excellent characteristics: Tg of 220°C, $\alpha$ of 4.9 x $10^{-5}$/K, flattening degree of 0.8, peeling strength of 580 gf/cm, tensile strength of 12 kgf/$mm^2$ and breaking elongation of 9 percent. It took up less than 0.001wt% copper (measured by the atomic absorption method). The color was yellow orange, and no problem was found in the soldering resistance test.

## EMBODIMENT 3

The same polyamic acid ester as in Embodiment 1 was used, with the N,N'-(4,4'-diphenylmethane) bismaleimide constituting 50wt% of its combination with the polyamic acid ester. A bonding varnish having a resin concentration of 50wt% in NMP solvent was made.

The dried and cured varnish and its bond exhibited excellent characteristics: Tg of 240°C, $\alpha$ of 4.9 x $10^{-5}$/K, flattening degree of 0.9, peeling strength of 630 gf/cm, tensile strength of 11 kgf/$mm^2$ and breaking elongation of 7 percent. It contained less than 0.001wt% absorbed copper (measured by the atomic absorption method). The color was yellow orange, and no deterioration was found in the soldering resistance test.

## EMBODIMENT 4

The same polyamic acid ester as in Embodiment 1 was used, with the N,N'-(4,4'-diphenylmethane) bismaleimide constituting 60wt% of the combination with the polyamic ester, and the bonding varnish having a resin concentration of 40wt%. Solvent was NMP.

The good characteristics were: Tg of 295°C, $\alpha$ of 4.3 x $10^{-5}$/K, flattening degree of 0.9, peeling strength of 650 gf/cm, tensile strength of 10 kgf/$mm^2$ and breaking elongation of 3 percent. The bonding layer contained less than 0.001wt% copper (measured by the atomic absorption method). The color was yellow orange, and no problem was found in the soldering resistance test.

## EMBODIMENT 5

60g of 1,3,5-tris(N-maleimide)-benzene and solvent was combined with 40g of the same polyamic acid ester as in Embodiment 1, and a bonding varnish having a resin concentration of 40wt% in NMP was produced.

Measurements on the product exhibited excellent characteristics: Tg of 310°C, α of 4.0 x $10^{-5}$/K, flattening degree of 0.8, peeling strength of 760 gf/cm, tensile strength of 9 kgf/$mm^2$ and breaking elongation of 3 percent. The bonding agent contained less than 0.001wt% copper (measured by the atomic absorption method). The color was yellow orange, and no problem was found in the soldering resistance test.

EMBODIMENT 6

40g of 2,2-bis[4-(4-N-phenoxymaleimide)phenyl]-propane and solvent were combined with 60g of the same polyamic acid ester as in Embodiment 1, giving a bonding varnish with a resin concentration of 40 wt%.

The good characteristics were:

Tg of 220°C, α of 4.2 x $10^{-5}$/K, flattening degree of 0.8, peeling strength of 890 gf/cm, tensile strength of 9 kgf/$mm^2$ and breaking elongation of 6 percent. Copper content was below 0.001 percent (measured by the atomic absorption method). The color was yellow orange, and no problem was found in the soldering resistance test.

EMBODIMENT 7

In the same way as in Embodiment 1, 60g of polyamic acid ester were produced from 3,3'4,4'-biphenyl tetracarboxylic acid dianhydride, ethanol and p-diamino diphenylether, and 40g of 2,2-bis[4-(4-N-phenoxymaleimide)phenyl]-phenoxypropane and NMP solvent were added to form a bonding varnish with a resin concentration of 40 wt%.

The characteristics, obtained as described above, were:

Tg of 335°C, α of 3.6 x $10^{-5}$/K, flattening degree of 0.8, peeling strength of 600 gf/cm, tensile strength of 12 kgf/$mm^2$ and breaking elongation of 5 percent. Copper content was below 0.001 percent (measured by the atomic absorption method). The color was yellow orange, and no problem was found in the soldering resistance test.

EMBODIMENT 8

2,2-bis[4-(4-N-phenoxymaleimide)phenyl]-phenoxypropane)-1 and 40g of 1,1,1,3,3,3-hexafluoropropane were added to 60g of a mixed polyamic acid ester obtained by equimolar mixing of a polyamic ester from 1,2,4,5-pyromellitic dianhydride, methanol and p-diamino diphenylether, and a polyamic acid ester obtained from 3,3',4,4'-benzophenone-tetracarboxylic acid dianhydride, methanol and p-diamino diphenylether, thereby producing a bonding varnish having a resin concentration of 40wt%.

Characteristics were:

Tg of 305°C, α of 4.2 x $10^{-5}$/K, flattening degree of 0.9, peeling strength of 1080 gf/cm, tensile strength of 16 kgf/$mm^2$ and breaking elongation of 12 percent. Copper takeup was below 0.001 percent (measured by the atomic absorption method). The color was yellow orange, and no problem was found in the soldering resistance test.

EMBODIMENT 9

2,2-bis[4-(2-N-trifluoromethyl-4-maleimidephenoxy)phenyl]-1 and 40g of 1,1,1,3,3,3-hexafluoropropane were added to 60g of the mixed polyamic acid ester used in Embodiment 8, thereby producing a bonding varnish having a resin concentration of 40wt%.

Characteristics were:

Tg of 300°C, α of 4.2 x $10^{-5}$/K, flattening degree of 0.9, peeling strength of 980 gf/cm, tensile strength of 15 kgf/$mm^2$ and breaking elongation of 12 percent. Copper content was below 0.001 percent (measured by the atomic absorption method). The color was yellow orange, and no problem was found in the soldering resistance test.

EMBODIMENT 10

32.2 grams of 3,3',4,4',-benzophenone-tetracarboxylic acid dianhydride, 41.0 grams of 2,2-bis(4-4-aminophenoxy) phenylpropane and 415 grams of NMP were put into a four-neck flask having an agitator, thermometer, nitrogen gas feed tube and cooling tube with calcium chloride tube, and nitrogen gas was passed while the reaction liquid was kept below 65°C and agitated for eight hours to obtain a polyamic acid varnish. 35 grams of N,N'-(4,4'-diphenylmethane) bismaleimide and NMP were added to 65 grams of this polyamic acid varnish, producing a bonding agent having a resin concentration of 20wt%. This was used to produce a multilayered wiring board, using the procedure given in Embodiment 1. The exposed copper face of the wiring was first protected with Ni, thickness about 100Å.

Characteristics were:

Tg of 220°C, α of 5.0 x $10^{-5}$/K, and flattening degree of 0.4. The peeling strength was low, so double coating was carried out. The peeling strength was 780 gf/cm, tensile strength 15 kgf/$mm^2$ and breaking elongation 11 percent.

Because of the Ni plating, it contained almost no copper after imidization. No problem was found in the soldering resistance test.

EMBODIMENT 11

Using the procedure of Embodiment 10, a polyamic acid was made from 3,3',4,4'-benzophenone tetracarboxylic acid dianhydride (0.5 mols), pyromellitic dianhydride (0.5 mols) and p-diamino diphenylether (1 mol), with 2,2-bis[4-(4-maleimidephenoxy)phenyl] and 40 wt% of 1,1,1,3,3,3,-hexafluoropropane to produce a bonding varnish having a resin concentration of 40wt%. This was used to produce a multilayered wiring board in conformity to the procedure given in Embodiment 1. The copper of the wiring was protected with Ni as before.

The following results were obtained:

Tg of 250°C, α of 4.9 x $10^{-5}$/K, and flattening degree of 0.6. The peeling strength was rather low, so double coating was carried out. The peeling strength was 580 gf/cm, tensile strength 12 kgf/$mm^2$ and breaking elongation 11 percent. Again, almost no copper was taken up. No problem was found in the soldering resistance test.

EMBODIMENT 12

Using the procedure of Embodiment 10, a polyamide acid was made from benzophenone tetracarboxylic acid dianhydride and 2,2-bis[4-(p-aminophenoxy)phenyl]propane in NMP. The polyamide acid was heated for polyimidization at temperatures of 100°C and 250°C, for 1 hour each. The polyimide was dissolved in NMP, and then combined with 2,2-bis[4-(4-maleimidephenoxy)phenyl], 40wt% of 1,1,1,3,3,3,-hexafluoropropane and NMP to produce a bonding varnish having a resin concentration of 40wt%. This was used to produce a multilayered wiring board in accordance with the procedure given in Embodiment 1. The copper of the wiring was initially protected with Ni of 100Å thickness.

The following results were obtained:

Tg of 220°C, α of 6.7 x $10^{-5}$/K, flattening degree of 0.8, peeling strength of 870 gf/cm, tensile strength of 10 kgf/$mm^2$, and breaking elongation of 10%. No problem was found in the soldering resistance test.

COMPARATIVE EXAMPLE

A prefabricated bonding film (obtained by the method described below) was placed between a wiring sheet to be fixed and another wiring sheet on a ceramic substrate, otherwise as shown in Fig. 1(b) used in Embodiment 1, and subjected to laminated pressing under the conditions of 0.1 mm Hg vacuum and 40 to 50 kgf/$cm^2$ pressure, at a temperature of 250°C for 30 minutes, thereby obtaining a laminate.

To make the mentioned bonding film, 2,2-bis(4,4-aminophenoxy) phenylpropane was dissolved in NMP, and equimolar 3,3',4,4'-benzophenone-tetracarboxylic acid dianhydride was added so that the total resin concentration was 30wt%. It was stirred at room temperature and polymerised to get a polyamic acid varnish. Then, 40wt% of bis(4-phenylmaleimide)-methane was added, and blended at room temperature. To produce a bonding film, the varnish was applied uniformly on a UBREX film (trade name of Ube Industries, Limited), and dried at a temperature of 100°C for 60 minutes. It was then further heated at a temperature of 200°C for 30 minutes and thereby imidized to produce a solidified layer 25μm thick.

Characteristics of the cured varnish and bonded product were:

Tg of 240°C, α of 4.9 x $10^{-5}$/K, peeling strength of 690 gf/cm, tensile strength of 8 kgf/$mm^2$ and breaking elongation of 6 percent. However, fluidity was not satisfactory owing to the bonding film method, and part of the boundary between the wiring and the bonding layer was insufficiently embedded. The soldering resistance test revealed peeling at the boundary between the bonding agent and wiring, arising in about one minute.

In the present process, bonding varnish is applied to a wiring sheet, dried and converted into the imide; then wiring sheets are laid on top of one another, and subjected to laminate pressing. By repetition of this typical process step, multilayers can be formed. This method features a conveniently simple process step. Use of the bonding varnish in situ enables substantially voidless lamination, even for wiring of high aspect ratio, thus offering insulated layers which feature high reliability and industrial value.

## Claims

**1.** A method of manufacturing a thin film wiring board for mounting a semiconductor chip, which comprises the steps of:

(a) providing a first wiring sheet (1) comprising a substrate (2) of a polymeric material and wiring (4) of a conductive material formed on the substrate (2);

(b) applying a liquid varnish layer (16) covering the wiring (4) and substrate surfaces between the wiring (4), said varnish comprising, in solution in organic solvent,

(i) soluble polyimide, polyamic acid ester, or a mixture thereof; and
(ii) a polymerizable compound, the weight proportions of the dissolved components (i):(ii) being in the range from 10:90 to 90:10;

(c) drying the varnish layer to form a hardenable layer (16) containing polyimide, while keeping the polymerizable compound unpolymerized;
(d) pressing the hardenable layer against a non-wired surface of a second wiring sheet; and
(e) polymerizing the polymerizable compound in the hardenable layer to bond the first wiring sheet to the second wiring sheet.

**2.** A method according to claim 1 in which the polyamic acid ester has repeating units of the formula

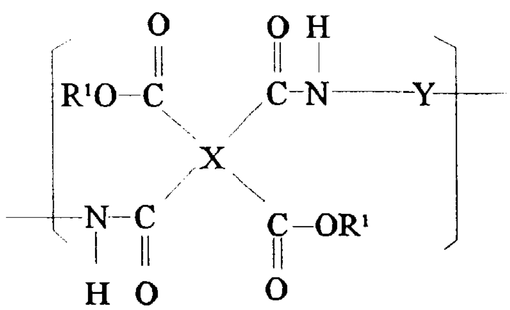

wherein X and Y are organic moieties having from 1 to 100 carbon atoms and $R^1$ is a carboxyl-group-free organic moiety having from 1 to 30 carbon atoms.

**3.** A method according to claim 2 in which, in the polyamic acid ester, X is the residue of a $C_6$ - $C_{50}$ aromatic dianhydride.

**4.** A method according to claim 2 or claim 3 in which Y is the residue of a $C_{6-50}$ aromatic diamine.

**5.** A method according to any one of the preceding claims in which the polymerizable compound is a thermosetting compound having vinylene, ethynyl, biphenylene or benzocyclobutene groups polymerizable by heat.

**6.** A method according to claim 5 in which the polymerizable compound has the general formula

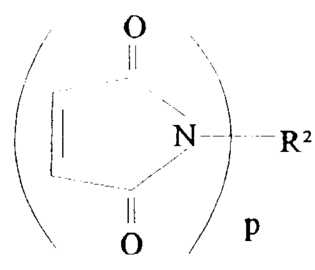

in which p is 2 or 3 and $R^2$ is an organic radical having not more than 100 carbon atoms.

**7.** A method according to claim 6 in which the polymerizable compound is selected from N,N'-(4,4'-diphenylmethane) bismaleimide, N,N'-(4,4'-diphenyloxy) bismaleimide, N,N'-phenylene bismaleimide, N,N'-m-phenylene bismaleimide, N,N'-2,4-tolylenebismaleimide, N,N'-2,6-tolylenebismaleimide, N,N'-2,4-ethylene bismaleimide, N,N'-hexamethylene bismaleimide, 2,2-bis[4-(4-N-phenoxymaleimide)phenyl] - propane, 2,2-bis[4-(4-N-phenoxymaleimide) phenyl] hexafluoropropane, 2,2-bis[4-(2-trifluoromethyl-4-N-phenoxymaleimide)phenyl] hexafluoropropane, 1,3,5-tris (N-maleimide) benzene and N,N',N"-(4,2',4' -diphenylmethane) trismaleimide.

**8.** A method according to any one of the preceding claims in which the organic solvent in the varnish is selected from N-methyl-2-pyrrolidone, dimethylacetoamide, dimethylformamide, diglyme, phenol, toluene and mixtures thereof.

**9.** A method according to any one of the preceding claims in which copper is the conductive material of the wiring (4).

**10.** A method according to any one of the preceding claims in which the wiring sheet substrate (2) is of polyimide.

**11.** A method according to any one of the preceding claims in which the varnish comprises said polyimide precursor, and step (c) comprises heating at a first, lower temperature to dry off the solvent and then heating at a second, higher temperature to form polyimide.

**12.** A method according to any one of the preceding claims in which during step (e) the first and second wiring sheets are pressed together with a pressure from 3 to 60 $kgf/cm^2$ (1 $kgf/cm^2$ = 0.9807 bar), and heated to thermoset the polymerizable compound.

**13.** A method according to any one of the preceding claims further comprising

(f) forming through-holes in the second wiring sheet;
(g) electrically connecting the wiring of the first wiring sheet with that of the second wiring sheet, through the through-holes, and
(h) repeating steps (b) to (g) until a desired number of wiring layers is achieved.

**Patentansprüche**

**1.** Verfahren zur Herstellung einer Dünnschichtleiterplatte zum Befestigen eines Halbleiterchips, das folgende Schritte umfaßt:

(a) Bereitstellen einer ersten Leiterschicht (1), welche ein Substrat (2) aus einem Polymerwerkstoffs und auf dem Substrat (2) gebildete Leiter (4) aus einem leitfähigen Material enthält;
(b) Aufbringen einer flüssigen Lackschicht (16), welche die Leiter (4) und die Substratoberflächen zwischen den Leitern (4) bedeckt, wobei der Lack in einem organischen Lösungsmittel in Lösung enthält:

(i) lösliches Polyimid, Polyamidsäureester oder ein Gemisch davon und
(ii) eine polymerisierbare Verbindung; wobei die Gewichtsverhältnisse der gelösten Komponenten (i):(ii) im Bereich von 10:90 bis 90:10 liegen;

(c) Trocknen der Lackschicht, wobei eine Polyimid enthaltende härtbare Schicht (16) gebildet wird, während die polymerisierbare Verbindung im unpolymerisierten Zustand gehalten wird;
(d) Pressen der härtbaren Schicht gegen eine leiterfreie Oberfläche einer zweiten Leiterschicht; und
(e) Polymerisieren der polymerisierbaren Verbindung in der härtbaren Schicht, wobei die erste Leiterschicht an die zweite Leiterschicht gebunden wird.

**2.** Verfahren gemäß Anspruch 1, wobei der Polyamidsäureester die Wiederholungseinheiten der Formel

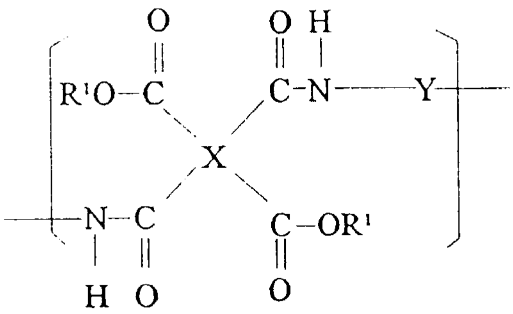

aufweist, worin X und Y organische Reste mit 1 bis 100 Kohlenstoffatomen sind und $R^1$ ein Carboxylgruppen-freier organischer Rest mit 1 bis 30 Kohlenstoffatomen ist.

3. Verfahren gemäß Anspruch 2, wobei in dem Polyamidsäureester X der Rest eines $C_6$-$c_{50}$-aromatischen Dianhydrids ist.

4. Verfahren gemäß Anspruch 2 oder 3, wobei Y der Rest eines $C_6$-$C_{50}$-aromatischen Diamins ist.

5. Verfahren gemäß einem der vorstehenden Ansprüche, wobei die polymerisierbare Verbindung eine wärmehärtbare Verbindung ist, die durch Wärme polymerisierbare Vinylen-, Ethinyl-, Biphenylen- oder Benzocyclobutengruppen enthält.

6. Verfahren gemäß Anspruch 5, wobei die polymerisierbare Verbindung die allgemeine Formel

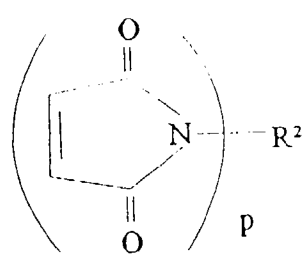

hat, worin p 2 oder 3 ist und $R^2$ ein organischer Rest mit nicht mehr als 100 Kohlenstoffatomen ist.

7. Verfahren gemäß Anspruch 6, wobei die polymerisierbare Verbindung unter N,N'-(4,4'-Diphenylmethan)bismaleimid, N,N'-(4,4'-Diphenyloxy)bismaleimid, N,N'-Phenylenbismaleimid, N,N'-m-Phenylenbismaleimid, N,N'-2,4-Toluolbismaleimid, N,N'-2,6-Toluolbismaleimid, N,N'-2,4-Ethylenbismaleimid, N,N'-Hexamethylenbismaleimid, 2,2-bis[4-(4-N-Phenoxymaleimid)phenyl]propan, 2,2-bis[4-(4-N-Phenoxymaleimid)phenyl]hexafluorpropan, 2,2-bis[4-(2-Trifluormethyl4-N-phenoxymaleimid)phenyl]hexafluorpropan, 1,3,5-tris(N-Maleimid)benzol und N,N', N''-(4,2',4'-Diphenylmethan)trismaleimid ausgewählt wird.

8. Verfahren gemäß einem der vorstehenden Ansprüche, wobei das organische Lösungsmittel in dem Lack unter N-Methyl-2-pyrrolidon, Dimethylacetamid, Dimethylformamid, Diglycolether, Phenol, Toluol und Gemischen davon ausgewählt ist.

9. Verfahren gemäß einem der vorstehenden Ansprüche, wobei das leitfähige Material des Leiters (4) Kupfer ist.

10. Verfahren gemäß einem der vorstehenden Ansprüche, wobei das Substrat (2) der Leiterschicht Polyimid ist.

11. Verfahren gemäß einem der vorstehenden Ansprüche, wobei der Lack den Polyimidvorläufer enthält und Stufe

(c) das Erwärmen bei einer ersten, niedrigeren Temperatur, wobei das Lösungsmittel durch Trocknen entfernt wird, und dann durch Erwärmen bei einer zweiten, höheren Temperatur unter Bildung des Polyimids umfaßt.

**12.** Verfahren gemäß einem der vorstehenden Ansprüche, wobei während Stufe (e) die erste und die zweite Leiterschicht mit einem Druck von 3 bis 60 $kgf/cm^2$ (1 $kgf/cm^2$ = 0,9807 bar) zusammengepreßt und erwärmt werden, wobei die polymerisierbare Verbindung wärmegehärtet wird.

**13.** Verfahren gemäß einem der vorstehenden Ansprüche, das weiter umfaßt:

(f) Bilden von durchgehenden Löchern in der zweiten Leiterschicht,
(g) elektrisches Verbinden der Leiter der ersten Leiterschicht mit denjenigen der zweiten Leiterschicht durch die durchgehenden Löcher und
(h) Wiederholen der Stufen (b) bis (g), bis die gewünschte Anzahl Leiterschichten erreicht ist.

## Revendications

**1.** Procédé de fabrication d'une plaque de connexions en un film mince pour monter une puce de semi-conducteur, qui comprend les étapes consistant :

(a) à préparer une première feuille de câblage (1) comprenant un substrat (2) en une matière polymère et un câblage (4) en une matière conductrice formée sur le substrat (2);
(b) à appliquer une couche de vernis liquide (16) recouvrant les surfaces du câblage (4) et du substrat entre le câblage (4), ledit vernis comprenant, en solution dans un solvant organique,

(i) un polyimide, un ester de poly(acide amidique) soluble, ou un mélange de ceux-ci; et
(ii) un composé polymérisable, les proportion pondérales des composants dissous (i):(ii) étant dans la gamme de 10:90 à 90:10;

(c) à sécher la couche de vernis pour former une couche durcissable (16) contenant le polyimide, tout en maintenant le composé polymérisable non polymérisé;
(d) à comprimer la couche durcissable contre une surface non câblée d'une seconde feuille de câblage; et
(e) à polymériser le composé polymérisable dans la couche durcissable pour lier la première feuille de câblage à la seconde feuille de câblage.

**2.** Procédé selon la revendication 1, dans lequel l'ester de poly(acide amidique) comporte des motifs récurrents de formule

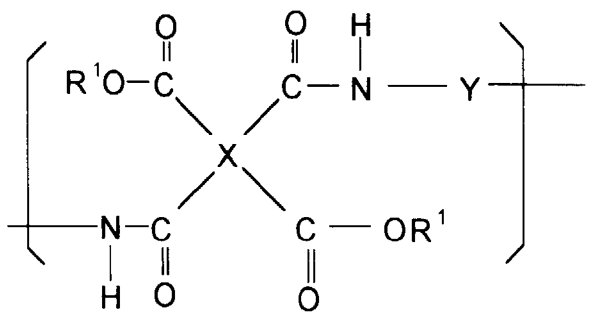

dans laquelle X et Y sont des groupements organiques comportant 1 à 100 atomes de carbone et $R^1$ est un groupement organique dépourvu de groupe carboxyle comportant 1 à 30 atomes de carbone.

**3.** Procédé selon la revendication 2 dans lequel, dans l'ester de poly(acide amidique), X est le résidu d'un dianhydride aromatique en $C_6$-$C_{50}$.

**4.** Procédé selon la revendication 2 ou 3, dans lequel Y est le résidu d'une diamine aromatique en $C_6$-$C_{50}$.

**5.** Procédé selon l'une quelconque des revendications précédentes, dans lequel le composé polymérisable est un composé thermodurcissable contenant des groupes vinylène, éthynyle, biphénylène ou benzocyclobutène, polymérisables sous l'action de la chaleur.

**6.** Procédé selon la revendication 5, dans lequel le composé polymérisable répond à la formule générale

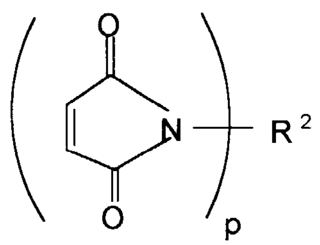

dans laquelle p vaut 2 ou 3, et $R^2$ est un radical organique ne comportant pas plus de 100 atomes de carbone.

**7.** Procédé selon la revendication 6, dans lequel le composé polymérisable est choisi parmi le N,N'-(4,4'-diphénylméthane) bismaléimide, le N,N'-(4,4'-diphényloxy) bismaléimide, le N,N'-phénylène bismaléimide, le N,N'-m-phénylène bismaléimide, le N,N'-2,4-tolylène bismaléimide, le N,N'-2,6-tolylène bismaléimide, le N,N'-2,4-éthylène bismaléimide, le N,N'-hexaméthylène bismaléimide, le 2,2-bis[4-(4-N-phénoxymaléimide)phényl]propane, le 2,2-bis[4-(4-N-phénoxymaléimide)phényl]hexafluoropropane, le 2,2-bis[4-(2-trifluorométhyl-4-N-phénoxymaléimide)phényl]-hexafluoropropane, le 1,3,5-tris(N-maléimide)bezène et le N,N',N"-(4,2',4'-diphénylméthane) trismaléimide.

**8.** Procédé selon l'une quelconque des revendications précédentes, dans lequel le solvant organique du vernis est choisi parmi la N-méthyl-2-pyrrolidone, le diméthylacétoamide, le diméthylformamide, la diglyme, le phénol, le toluène et des mélanges de ceux-ci.

**9.** Procédé selon l'une quelconque des revendications précédentes, dans lequel le cuivre est la matière conductrice du câblage (4).

**10.** Procédé selon l'une quelconque des revendications précédentes, dans lequel le substrat de feuille de câblage (2) est en polyimide.

**11.** Procédé selon l'une quelconque des revendications précédentes, dans lequel le vernis comprend ledit précurseur de polyimide, et l'étape (c) comprend le chauffage à une première température plus basse pour évaporer le solvant, puis le chauffage à une seconde température plus élevée pour former le polyimide.

**12.** Procédé selon l'une quelconque des revendications précédentes dans lequel, pendant l'étape (e), les première et seconde feuilles de câblage sont comprimées l'une contre l'autre sous une pression de 3 à 60 kgf/cm$^2$ (1 kgf/cm$^2$ = 0,9807 bar), et sont chauffées pour thermodurcir le composé polymérisable.

**13.** Procédé selon l'une quelconque des revendications précédentes comprenant, en outre,

(f) la formation de trous de passage dans la seconde feuille de câblage;
(g) la connexion électrique du câblage de la première feuille de câblage avec celui de la seconde feuille de câblage, par les trous traversants, et
(h) la répétition des étapes (b) à (g) jusqu'à l'obtention du nombre voulu de couches de câblage.

Fig.1a.

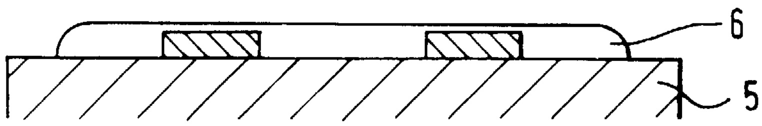


Fig.1b.

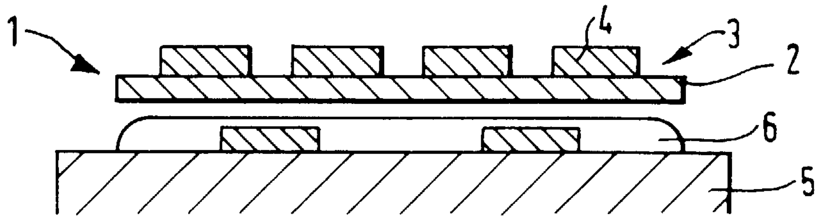


Fig.1c.

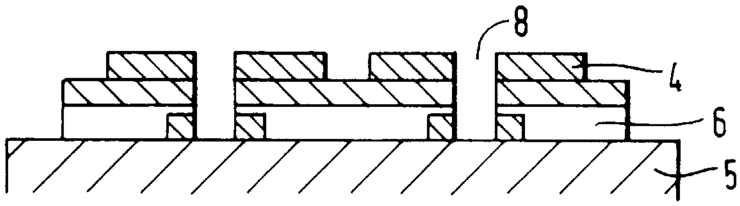


Fig.1d.

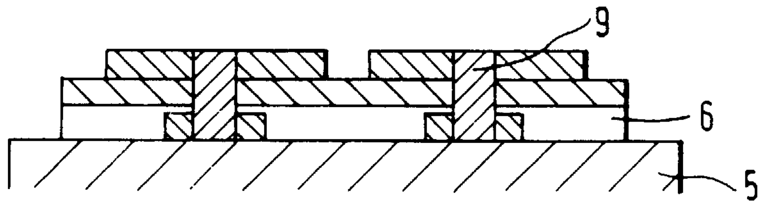


Fig.1e.

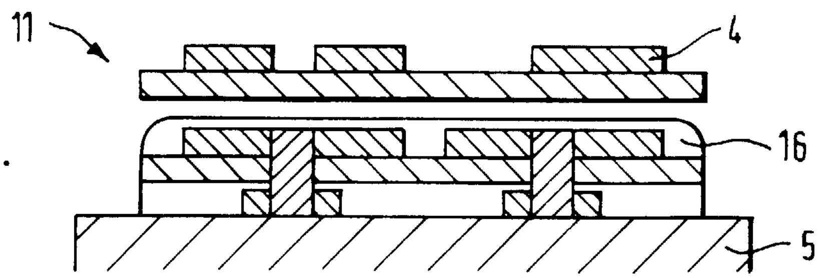


Fig.1f